# EUROPEAN PATENT SPECIFICATION

(11) **EP 2 298 955 B1**
(45) Date of publication and mention of the grant of the patent: **15.10.2014**
(21) Application number: 10176489.2
(22) Date of filing: 13.09.2010
(51) Int. Cl.: C23C 16/24, H01L 31/18, H01L 31/20

(54) **Additives to silane for thin film silicon photovoltaic devices**
Additive für Silan für Dünnschicht-Photovoltaik-Bauelemente
Additifs pour silane pour les éléments photovoltaiques à base de couches minces de silicium

(30) Priority: 11.09.2009 US 241466 P; 31.08.2010 US 872806
(43) Date of publication of application: 23.03.2011
(73) Proprietor: AIR PRODUCTS AND CHEMICALS, INC., Allentown, PA 18195-1501 (US)
(72) Inventor: Hurley, Patrick Timothy, Allentown, PA 18104 (US); Ridgeway, Robert Gordon, Quakertown, PA 18951 (US); Hutchison, Katherine Anne, Sunnyvale, CA 94086 (US); Langan, John Giles, Breinigsville, PA 18031 (US)
(74) Representative: Beck Greener

(56) References cited:
- EP-A2- 0 229 707
- GB-A- 2 319 662
- US-A- 5 017 308
- GUO LIHUI ET AL: "Low-temperature growth of crystalline silicon on a chlorine-terminated surface" APPLIED PHYSICS LETTERS, AIP, AMERICAN INSTITUTE OF PHYSICS, MELVILLE, NY, US LNKD- DOI:10.1063/1.125373, vol. 75, no. 22, 29 November 1999 (1999-11-29), pages 3515-3517, XP012024165 ISSN: 0003-6951
- NISHIMOTO T ET AL: "Effect of halogen additives on the stability of a-Si:H films deposited at a high-growth rate" SOLAR ENERGY MATERIALS AND SOLAR CELLS, ELSEVIER SCIENCE PUBLISHERS, AMSTERDAM, NL LNKD- DOI:10.1016/S0927-0248(00)00171-9, vol. 66, no. 1-4, 1 February 2001 (2001-02-01), pages 179-185, XP004224673 ISSN: 0927-0248
- HAN DAXING ET AL: "Hydrogen structures and the optoelectronic properties in transition films from amorphous to microcrystalline silicon prepared by hot-wire chemical vapor deposition" JOURNAL OF APPLIED PHYSICS, AMERICAN INSTITUTE OF PHYSICS. NEW YORK, US LNKD- DOI:10.1063/1.1555680, vol. 93, no. 7, 1 April 2003 (2003-04-01), pages 3776-3783, XP012059306 ISSN: 0021-8979

## Description

### BACKGROUND OF THE INVENTION

Photovoltaic devices (PV) or solar cells are devices which convert sunlight into direct current (DC) electrical power.

Thin Film based Photovoltaic (TFPV) devices have been using both amorphous silicon film (αSi:H) and microcrystalline silicon film (µCSi:H) for low cost thin film photovoltaic devices. Hydrogenated amorphous silicon (αSi:H) has been studied for applications in solar cells for several decades. More recently, microcrystalline silicon (µCSi:H) has been studied because it is a suitable material for the intrinsic layer in the bottom cell of thin-film tandem solar cells.

The deposition of αSi:H and µCSi:H on large substrate based photovoltaic (PV) panels has been accomplished primarily using silane (SiH₄) and hydrogen (H₂) gas mixtures. The work have been done in the field includes: US2009/0077805 A1, US2007/0298590 A1), US6855621 B2 and JP2005244037. A. Hammad et al (Thin Solid Films 451-452 (2004) 255-258) studied the hydrogenated microcrystalline silicon thin films using silane (SiH₄), hydrogen gases ( H₂ ) and disilane (Si₂H₆).

However, the deposition processes are relatively slow (5- 10 Å/sec for αSi:H and 1-7 Å/sec for µCSi:H ) creating a bottle neck in the manufacturing of TFPV panels. This leads to a lower process tool through-put, which in turn leads to higher cost per Watt for the manufactured panels.

GB2319662A discloses a method for the deposition of a silicon film using a mixture of silane (SiH₄) and H₂. It also teaches that instead of or in addtion to silane, other gases such as Si₂H₆, Si(CH₃)₄, SiF₄, SiHF₃, Si₂H₂Cl₄ and gasses having the general formula Si_{N}H_{2N+2M}Y_{M} may be used.

Additionally, deposition of αSi:H and µCSi:H on large substrate based photovoltaic (PV) panels with the existing chemistry of SiH₄ and H₂ yield solar cells with efficiencies ranging from 6% to 10%, depending on cell design. The cell efficiency is dependent upon the quality of the αSi:H and µCSi:H deposited, and more specifically related to the grain size of crystallites in µCSi:H, number of defects and donor impurities present in the film.

Therefore, there is a need of a method for depositing an amorphous silicon film (αSi:H ) and a microcrystalline silicon film (µCSi:H ) with increased deposition rate and increased cell efficiency.

### BRIEF SUMMARY OF THE INVENTION

Accordingly, the present invention provides a method of deposition according to claim 1 for an amorphous silicon film or microcrystalline silicon film as a photoconductive film on a substrate, and hence concerns to the use of chemical additives to increase the rate of deposition processes, and improve the electrical current generating capability of the deposited films for photoconductive films used in the manufacturing of Thin Film based Photovoltaic (TFPV) devices.

In one embodiment, the invention provides a method of deposition for an amorphous silicon film (αSi:H) or microcrystalline silicon film (µCSi:H). Preferably, the method is a method of deposition for a solar grade amorphous silicon film (αSi:H) as a photoconductive film on a substrate. The method in this embodiment uses
Silane;
hydrogen; and
at least one additive selected from:
(a) higher order straight chain silanes, selected from; disilane Si₂H₆, trisilane Si₃H₈, tetrasilane Si₄H₁₀, pentasilane Si₅H₁₂, hexasilane Si₆H₁₄, heptasilane Si₇H₁₆, octasilane Si₈H₁₈, nonasilane Si₉H₂₀, decasilane Si₁₀H₂₂, other straight chain silanes of the general formula SiₓH₂ₓ₊₂ where x is 2 to 20, and mixtures thereof;
(b) higher order branched silanes, selected from; 2-silyl-trisilane SiH₃-Si(H)(SiH₃)-SiH₃, 2,2-disilyl-trisilane SiH₃-Si(SiH₃)₂-SiH₃, 2-silyl-tetrasilane SiH₃-Si(H)(SiH₃)-SiH₂-SiH₃, 2,3-disilyltetrasilane SiH₃-SiH(SiH₃)-SiH(SiH₃)-SiH₃, 2,2-disilyltetrasilane SiH₃-Si(SiH₃)₂-SiH₂-SiH₃, 3-silylpentasilane SiH₃-SiH₂-SiH(SiH₃)-SiH₂-SiH₃, 2-silylpentasilane SiH₃-SiH(SiH₃)-SiH₂-SiH₂-SiH₃, 2,3-disilylpentasilane SiH₃-SiH(SiH₃)-SiH(SiH₃)-SiH₂-SiH₃, 2,4-disilylpentasilane SiH₃-SiH(SiH₃)-SiH₂-SiH(SiH₃)-SiH₃, 2-silylhexasilane SiH₃-SiH(SiH₃)-(SiH₂)₃SiH₃, 3-silylhexasilane SiH₃-SiH₂-SiH(SiH₃)-(SiH₂)₂SiH₃, 2,2-disilylpentasilane SiH₃-Si(SiH₃)₂-(SiH₂)₂-SiH₃, 3,3-disilylpentasilane SiH₃-SiH₂-Si (SiH₃)₂-SiH₂ -SiH₃, 2,2,3-trisilyltetrasilane SiH₃-Si(SiH₃)₂-SiH(SiH₃)-SiH₃, 2-silylheptasilane SiH₃-SiH(SiH₃)-(SiH₂)₄-SiH₃, 3-silylheptasilane SiH₃-SiH₂-SiH(SiH₃)-(SiH₂)₃-SiH₃, 4-silylheptasilane SiH₃-(SiH₂)₂-SiH(SiH₃)-(SiH₂)₂-SiH₃, 2,2-disilylhexasilane SiH₃-Si(SiH₃)₂-(SiH₂)₃-SiH₃, 2,3-disilylhexasilane SiH₃-SiH(SiH₃) -SiH(SiH₃)-(SiH₂)₂-SiH₃, 2,4-disilylhexasilane SiH₃-SiH(SiH₃)-SiH₂-SiH(SiH₃)-SiH₂-SiH₃, 2,5-disilylhexasilane SiH₃-SiH(SiH₃)-(SiH₂)₂-SiH(SiH₃)- SiH₃, 3,3-disilylhexasilane SiH₃-SiH₂-Si(SiH₃)₂-(SiH₂)₂-SiH₃, 3,4-disilylhexasilane SiH₃-SiH₂-SiH(SiH₃)- SiH(SiH₃)-SiH₂-SiH₃, 2,2,3-trisilylpentasilane SiH₃-Si(SiH₃)₂-SiH(SiH₃)-SiH₂-SiH₃, 2,2,4-trisilylpentasilane SiH₃-Si(SiH₃)₂-SiH₂-SiH(SiH₃)-SiH₃, 2,3,3-trisilylpentasilane SiH₃-SiH(SiH₃)-Si(SiH₃)₂-SiH₂-SiH₃, 2,3,4-trisilylpentasilane SiH₃-SiH(SiH₃)-SiH(SiH₃)-SiH(SiH₃)-SiH₃, 2,2,3,3-tetrasilyltetrasilane SiH₃-Si(SiH₃)₂-Si(SiH₃)₂-SiH₃, other branched silanes of the general formula SiₓH₂ₓ₊₂ where x is 4 to 20, and mixtures thereof;
(c) cyclic silanes, selected from; cyclotrisilane Si₃H₆, cyclotetrasilane Si₄H₈, cyclopentasilane Si₅H₁₀, cyclohexasilane Si₆H₁₂, other cyclic silanes of the general formula SiₓH₂ₓ where x is 3 to 20, and mixtures thereof;
(d) silyl substituted cyclic silanes, selected from; silyl cyclotetrasilane SiH3-Si₄H₇, 1,2-disilyl cyclopentasilane (SiH₃)₂-Si₅H₈, silyl cyclohexasilane SiH₃-Si₆H₁₁, 1,3-disilyl cyclohexasilane (SiH₃)₂-Si₆H₁₀, other silyl substituted cyclosilanes of the general formula Si_{y}H_{3y}-SiₓH_{2x-y} where x is 3 to 20 and y is 1 to 2x, and mixtures thereof;
(e) silyl substituted silenes, selected from; 2-tetrasilene SiH₃-SiH=SiH-SiH₃, 2,3-disilyltetrasil-2-ene SiH₃-Si(SiH₃)=Si(SiH₃)-SiH₃, 2,3-disilylpentasil-2-ene SiH₃-Si(SiH₃)=Si(SiH₃)-SiH₂-SiH₃, 2,5-disilylhexasil-2-ene SiH₃-Si(SiH₃)=SiH-SiH2-SiH(SiH₃)-SiH₃, 2,3,4-trisilylhexasil-2-ene SiH₃-Si(SiH₃)=Si(SiH₃)-SiH(SiH₃)-SiH₂-SiH₃, other silyl substituted silenes of the general formula Si_{y}H_{3y}-SiₓH_{2x-y} where x is 2 to 20 and y is 1 to 2x, and mixtures thereof; and wherein the silane used is at 5% to 10% (v/v), the at least one additive used is at 0.01 to 5% (v/v), and the rest is hydrogen.

In another embodiment, the invention provides a method of deposition for amorphous silicon film (αSi:H) or microcrystalline silicon film (µCSi:H) as a photoconductive film on a substrate, using
Silane;
hydrogen;
at least one additive selected from:
(a) higher order straight chain silanes, selected from; disilane Si₂H₆, trisilane Si₃H₈, tetrasilane Si₄H₁₀, pentasilane Si₅H₁₂, hexasilane Si₆H₁₄, heptasilane Si₇H₁₆, octasilane Si₈H₁₈, nonasilane Si₉H₂₀, decasilane Si₁₀H₂₂, other straight chain silanes of the general formula SiₓH₂ₓ₊₂ where x is 2 to 20, and mixtures thereof;
(b) higher order branched silanes, selected from; 2-silyl-trisilane SiH₃-Si(H)(SiH₃)-SiH₃, 2,2-disilyl-trisilane SiH₃-Si(SiH₃)₂-SiH₃, 2-silyl-tetrasilane SiH₃-Si(H)(SiH₃)-SiH₂-SiH₃, 2,3-disilyltetrasilane SiH₃-SiH(SiH₃)-SiH(SiH₃)-SiH₃, 2,2-disilyltetrasilane SiH₃-Si(SiH₃)₂-SiH₂-SiH₃, 3-silylpentasilane SiH₃-SiH₂-SiH(SiH₃)-SiH₂-SiH₃, 2-silylpentasilane SiH₃-SiH(SiH₃)-SiH₂-SiH₂-SiH₃, 2,3-disilylpentasilane SiH₃-SiH(SiH₃)-SiH(SiH₃)-SiH₂-SiH₃, 2,4-disilylpentasilane SiH₃-SiH(SiH₃)-SiH₂-SiH(SiH₃)-SiH₃, 2-silylhexasilane SiH₃-SiH(SiH₃)-(SiH₂)₃SiH₃, 3-silylhexasilane SiH₃-SiH₂-SiH(SiH₃)-(SiH₂)₂SiH₃, 2,2-disilylpentasilane SiH₃-Si(SiH₃)₂-(SiH₂)₂-SiH₃, 3,3-disilylpentasilane SiH₃-SiH₂-Si (SiH₃)₂-SiH₂ -SiH₃, 2,2,3-trisilyltetrasilane SiH₃-Si(SiH₃)₂-SiH(SiH₃)-SiH₃, 2-silylheptasilane SiH₃-SiH(SiH₃)-(SiH₂)₄-SiH₃, 3-silylheptasilane SiH₃-SiH₂-SiH(SiH₃)-(SiH₂)₃-SiH₃, 4-silylheptasilane SiH₃-(SiH₂)₂-SiH(SiH₃)-(SiH₂)₂-SiH₃, 2,2-disilylhexasilane SiH₃-Si(SiH₃)₂-(SiH₂)₃-SiH₃, 2,3-disilylhexasilane SiH₃-SiH(SiH₃) -SiH(SiH₃)-(SiH₂)₂-SiH₃, 2,4-disilylhexasilane SiH₃-SiH(SiH₃)-SiH₂-SiH(SiH₃)-SiH₂-SiH₃, 2,5-disilylhexasilane SiH₃-SiH(SiH₃)-(SiH₂)₂-SiH(SiH₃)- SiH₃, 3,3-disilylhexasilane SiH₃-SiH₂-Si(SiH₃)₂-(SiH₂)₂-SiH₃, 3,4-disilylhexasilane SiH₃-SiH₂-SiH(SiH₃)- SiH(SiH₃)-SiH₂-SiH₃, 2,2,3-trisilylpentasilane SiH₃-Si(SiH₃)₂-SiH(SiH₃)-SiH₂-SiH₃, 2,2,4-trisilylpentasilane SiH₃-Si(SiH₃)₂-SiH₂-SiH(SiH₃)-SiH₃, 2,3,3-trisilylpentasilane SiH₃-SiH(SiH₃)-Si(SiH₃)₂-SiH₂-SiH₃, 2,3,4-trisilylpentasilane SiH₃-SiH(SiH₃)-SiH(SiH₃)-SiH(SiH₃)-SiH₃, 2,2,3,3-tetrasilyltetrasilane SiH₃-Si(SiH₃)₂-Si(SiH₃)₂-SiH₃, other branched silanes of the general formula SiₓH₂ₓ₊₂ where x is 4 to 20, and mixtures thereof;
(c) cyclic silanes, selected from; cyclotrisilane Si₃H₆, cyclotetrasilane Si₄H₈, cyclopentasilane Si₅H₁₀, cyclohexasilane Si₆H₁₂, other cyclic silanes of the general formula SiₓH₂ₓ where x is 3 to 20, and mixtures thereof;
(d) silyl substituted cyclic silanes, selected from; silyl cyclotetrasilane SiH3-Si₄H₇, 1,2-disilyl cyclopentasilane (SiH₃)₂-Si₅H₈, silyl cyclohexasilane SiH₃-Si₆H₁₁, 1,3-disilyl cyclohexasilane (SiH₃)₂-Si₆H₁₀, other silyl substituted cyclosilanes of the general formula Si_{y}H_{3y}-SiₓH_{2x-y} where x is 3 to 20 and y is 1 to 2x, and mixtures thereof;
(e) silyl substituted silenes, selected from; 2-tetrasilene SiH₃-SiH=SiH-SiH₃, 2,3-disilyltetrasil-2-ene SiH₃-Si(SiH₃)=Si(SiH₃)-SiH₃, 2,3-disilylpentasil-2-ene SiH₃-Si(SiH₃)=Si(SiH₃)-SiH₂-SiH₃, 2,5-disilylhexasil-2-ene SiH₃-Si(SiH₃)=SiH-SiH2-SiH(SiH₃)-SiH₃, 2,3,4-trisilylhexasil-2-ene SiH₃-Si(SiH₃)=Si(SiH₃)-SiH(SiH₃)-SiH₂-SiH₃, other silyl substituted silenes of the general formula Si_{y}H_{3y}-SiₓH_{2x-y} where x is 2 to 20 and y is 1 to 2x, and mixtures thereof;
   and
   at least one additional additive selected from:
(h) halogen substituted silenes, selected from; monochlorosilane SiH₃Cl, dichlorosilane SiH₂Cl₂, trichlorosilane SiHCl₃, tetrachlorosilane (SiCl₄), chlorodisilane SiH₃-SiH₂Cl, and mixtures thereof; and
(i) halogen containing gases, selected from; chlorine Cl₂, hydrogen chloride HCl, chlorine trifluoride ClF₃, nitrogen trifluoride NF₃, fluorine F₂, hydrogen fluoride HF, bromine Br₂, hydrogen bromide HBr, hydrogen iodide HI and mixtures thereof; and wherein the silane used is at 5 to 10% (v/v), the at least one additive used is at 0.01 to 5% (v/v), the at least one additional additive used is at 0.01 to 5% (v/v), and the rest is hydrogen.

### BRIEF DESCRIPTION OF SEVERAL VIEWS OF THE DRAWINGS

Figure 1. The Empirical Microstructure Factor R* of hydrogenated silicon α Si:H versus SiH₄ flow rate under different power densities. The hydrogenated silicon αSi:H was deposited using silane and hydrogen.
Figure 2. The deposition rate of hydrogenated silicon αSi:H versus SiH₄ flow rate under different power densities. The hydrogenated silicon αSi:H was deposited using silane and hydrogen.
Figure 3. The deposition rate of hydrogenated silicon αSi:H versus the flow rate of the mixture of SiH4 and disilane under different power densities. The hydrogenated silicon αSi:H was deposited using silane, disilane and hydrogen.
Figure 4. The Empirical Microstructure Factor R^{*} of hydrogenated silicon αSi:H versus the flow rate of the mixture of SiH4 and disilane under different power densities. The hydrogenated silicon αSi:H was deposited using silane, disilane and hydrogen.
Figure 5. The microcrystalline fraction versus the mole fraction SiH₃Cl / (SiH₃Cl + SiₓH_{y}).
Figure 6. The Activation Energy for deposited microcrystalline film versus the mole fractions of halogenated silanes SiH₃Cl / (SiH₃Cl + SiₓH_{y}).

### DETAILED DESCRIPTION OF THE INVENTION

In prior arts, Plasma power, frequency, temperature, gas mixing ratios and pressure have been used to control film structure, thickness and electrical properties.

The present invention further discloses the use of chemical additives to increase the rate of deposition processes, and improve the electrical current generating capability of the deposited films for photoconductive films used in the manufacturing of Thin Film based Photovoltaic (TFPV) devices.

Increasing the module efficiency is one approach for reducing manufacturing costs. The present invention discloses the reduction of manufacturing costs through the addition of additives to the mixture of SiH₄ and H₂.

In present invention, the additives are used to increase the deposition rate, and in addition, to control film structure to achieve better grade for practical use, to optimize crystalline grain sizes, reduce the number of defects and/or minimize or neutralize the effects of impurities present as a result of contamination from the processing environment; thus reducing manufacturing costs.

More specifically, the present invention uses the mixture of silane and hydrogen as the primary source of silicon, and uses additives as the process enhancing feature. The process enhancements are significantly greater than the potential additional cost afforded by the use of higher value additives. These enhancements lead to a lower cost per unit of energy through: (i) a faster deposition rate and better control of film grade resulting from the addition of relatively low mole fractions of higher order silanes; and, (ii) a more photoconductive film through the addition of a halogen containing gas or a halogen substituted silane containing gas.

The deposition processes include but are not limited to Chemical Vapor Deposition (CVD), Plasma Enhanced Chemical Vapor Deposition (PECVD), Low Pressure Chemical Vapor Deposition (LPCVD), Hot Wire Chemical Vapor Deposition (HWCVD), Initiated Chemical Vapor Deposition (ICVD) and Sub Atmospheric Chemical Vapor Deposition (SA-CVD).

Process enhancing additives include, but are not limited to:
(a) Higher order straight chain silanes, including; disilane Si₂H₆, trisilane Si₃H₈, tetrasilane Si₄H₁₀, pentasilane Si₅H₁₂, hexasilane Si₆H₁₄, heptasilane Si₇H₁₆, octasilane Si₈H₁₈, nonasilane Si₉H₂₀, decasilane Si₁₀H₂₂ and other straight chain silanes following the general formula SiₓH₂ₓ₊₂ where x can be 2-20;
(b) Higher order branched silanes, including; 2-silyl-trisilane SiH₃-Si(H)(SiH₃)-SiH₃, 2,2-disilyl-trisilane SiH₃-Si(SiH₃)₂-SiH₃, 2-silyl-tetrasilane SiH₃-Si(H)(SiH₃)-SiH₂-SiH₃, 2,3-disilyltetrasilane SiH₃-SiH(SiH₃)-SiH(SiH₃)-SiH₃, 2,2-disilyltetrasilane SiH₃-Si(SiH₃)₂-SiH₂-SiH₃, 3-silylpentasilane SiH₃-SiH₂-SiH(SiH₃)-SiH₂-SiH₃, 2-silylpentasilane SiH₃-SiH(SiH₃)-SiH₂-SiH₂-SiH₃, 2,3-disilylpentasilane SiH₃-SiH(SiH₃)-SiH(SiH₃)-SiH₂-SiH₃, 2,4-disilylpentasilane SiH₃-SiH(SiH₃)-SiH₂-SiH(SiH₃)-SiH₃, 2-silylhexasilane SiH₃-SiH(SiH₃)-(SiH₂)₃SiH₃, 3-silylhexasilane SiH₃-SiH₂-SiH(SiH₃)-(SiH₂)₂SiH₃, 2,2-disilylpentasilane SiH₃-Si(SiH₃)₂-(SiH₂)₂-SiH₃, 3,3-disilylpentasilane SiH₃-SiH₂-Si (SiH₃)₂-SiH₂ -SiH₃, 2,2,3-trisilyltetrasilane SiH₃-Si(SiH₃)₂-SiH(SiH₃)-SiH₃, 2-silylheptasilane SiH₃-SiH(SiH₃)-(SiH₂)₄-SiH₃, 3-silylheptasilane SiH₃-SiH₂-SiH(SiH₃)-(SiH₂)₃-SiH₃, 4-silylheptasilane SiH₃-(SiH₂)₂-SiH(SiH₃)-(SiH₂)₂-SiH₃, 2,2-disilylhexasilane SiH₃-Si(SiH₃)₂-(SiH₂)₃-SiH₃, 2,3-disilylhexasilane SiH₃-SiH(SiH₃) -SiH(SiH₃)-(SiH₂)₂-SiH₃, 2,4-disilylhexasilane SiH₃-SiH(SiH₃)-SiH₂-SiH(SiH₃)-SiH₂-SiH₃, 2,5-disilylhexasilane SiH₃-SiH(SiH₃)-(SiH₂)₂-SiH(SiH₃)- SiH₃, 3,3-disilylhexasilane SiH₃-SiH₂-Si(SiH₃)₂-(SiH₂)₂-SiH₃, 3,4-disilylhexasilane SiH₃-SiH₂-SiH(SiH₃)- SiH(SiH₃)-SiH₂-SiH₃, 2,2,3-trisilylpentasilane SiH₃-Si(SiH₃)₂-SiH(SiH₃)-SiH₂-SiH₃, 2,2,4-trisilylpentasilane SiH₃-Si(SiH₃)₂-SiH₂-SiH(SiH₃)-SiH₃, 2,3,3-trisilylpentasilane SiH₃-SiH(SiH₃)-Si(SiH₃)₂-SiH₂-SiH₃, 2,3,4-trisilylpentasilane SiH₃-SiH(SiH₃)-SiH(SiH₃)-SiH(SiH₃)-SiH₃, 2,2,3,3-tetrasilyltetrasilane SiH₃-Si(SiH₃)₂-Si(SiH₃)₂-SiH₃ and any other higher branched silanes under the general formula SiₓH₂ₓ₊₂ where x can be 4-20;
(c) Cyclic silanes, including; cyclotrisilane Si₃H₆, cyclotetrasilane Si₄H₈, cyclopentasilane Si₅H₁₀, cyclohexasilane Si₆H₁₂, and other cyclic silanes consisting of the general formula SiₓH₂ₓ where x can be 3-20;
(d) Silyl substituted cyclic silanes, including; silyl cyclotetrasilane SiH₃-Si₄H₇, 1,2-disilyl cyclopentasilane (SiH₃)₂-Si₅H₈, silyl cyclohexasilane SiH₃-Si₆H₁₁, 1,3-disilyl cyclohexasilane (SiH₃)₂-Si₆H₁₀, and other silyl substituted cyclosilanes of the general formula Si_{y}H_{3y}-SixH_{2x-y} where x can be 3 to 20 and y can be 1 to 2x.
(e) Silyl substituted silenes, including; 2-tetrasilene SiH₃-SiH=SiH-SiH₃, 2,3-disilyltetrasil-2-ene SiH₃-Si(SiH₃)=Si(SiH₃)-SiH₃, 2,3-disilylpentasil-2-ene SiH₃-Si(SiH₃)=Si(SiH₃)-SiH₂-SiH₃, 2,5-disilylhexasil-2-ene SiH₃-Si(SiH₃)=SiH-SiH2-SiH(SiH₃)-SiH₃, 2,3,4-trisilylhexasil-2-ene SiH₃-Si(SiH₃)=Si(SiH₃)-SiH(SiH₃)-SiH₂-SiH₃, and other silyl substituted silenes of the general formula Si_{y}H_{3y}-SiₓH_{2x-(y+2)} where x can be 2 - 20 and y can be 1 to 2x.
(h) Halogen substituted silanes, including; monochlorosilane SiH₃Cl, dichlorosilane SiH₂Cl₂, trichlorosilane SiHCl₃, tetrachlorosilane (SiCl₄), and chlorodisilane SiH₃-SiH₂Cl.
(i) Halogen containing gases, including; chlorine Cl₂, hydrogen chloride HCl, chlorine trifluoride ClF₃, nitrogen trifluoride NF₃, fluorine F₂, hydrogen fluoride HF, bromine Br₂, hydrogen bromide HBr, hydrogen iodide Hl and other compounds of these types.

To increase the deposition rate and improve the photoconductivity of the film, one embodiment of the present invention uses at least one additive selected from the groups (a) to (e) shown above in addition of SiH₄ and H₂; yet another embodiment of the present invention uses the combinations of additives from groups (a) to (e) and additives from groups (h) and (i) to further enhance the photoconductivity of the film.

The depositions use 5 to 10% silane; from 0.01 to 5% an additive from groups (a) to (e); 0.01 to 5% an additive from groups (h) and (i) (where used); and the remainder hydrogen; the flow of hydrogen, silane, and appropriate additive or additives totalling 100% (all said percentages being by volume).

Aspects of the invention include:
#1. A method of deposition for a solar grade amorphous silicon film (αSi:H) as a photoconductive film on a substrate, using
   Silane;
   hydrogen; and
   at least one additive selected from the group consisting of:
   (a) higher order straight chain silanes, comprising; disilane Si₂H₆, trisilane Si₃H₈, tetrasilane Si₄H₁₀, pentasilane Si₅H₁₂, hexasilane Si₆H₁₄, heptasilane Si₇H₁₆, octasilane Si₈H₁₈, nonasilane SigH₂₀, decasilane Si₁₀H₂₂ and mixtures thereof;
   (b) higher order branched silanes, comprising; 2-silyl-trisilane SiH₃-Si(H)(SiH₃)-SiH₃, 2,2-disilyl-trisilane SiH₃-Si(SiH₃)₂-SiH₃, 2-silyl-tetrasilane SiH₃-Si(H)(SiH₃)-SiH₂-SiH₃, 2,3-disilyltetrasilane SiH₃-SiH(SiH₃)-SiH(SiH₃)-SiH₃, 2,2-disilyltetrasilane SiH₃-Si(SiH₃)₂-SiH₂-SiH₃, 3-silylpentasilane SiH₃-SiH₂-SiH(SiH₃)-SiH₂-SiH₃, 2-silylpentasilane SiH₃-SiH(SiH₃)-SiH₂-SiH₂-SiH₃, 2,3-disilylpentasilane SiH₃-SiH(SiH₃)-SiH(SiH₃)-SiH₂-SiH₃, 2,4-disilylpentasilane SiH₃-SiH(SiH₃)-SiH₂-SiH(SiH₃)-SiH₃, 2-silylhexasilane SiH₃-SiH(SiH₃)-(SiH₂)₃SiH₃, 3-silylhexasilane SiH₃-SiH₂-SiH(SiH₃)-(SiH₂)₂SiH₃, 2,2-disilylpentasilane SiH₃-Si(SiH₃)₂-(SiH₂)₂-SiH₃, 3,3-disilylpentasilane SiH₃-SiH₂-Si (SiH₃)₂-SiH₂ -SiH₃, 2,2,3-trisilyltetrasilane SiH₃-Si(SiH₃)₂-SiH(SiH₃)-SiH₃, 2-silylheptasilane SiH₃-SiH(SiH₃)-(SiH₂)₄-SiH₃, 3-silylheptasilane SiH₃-SiH₂-SiH(SiH₃)-(SiH₂)₃-SiH₃, 4-silylheptasilane SiH₃-(SiH₂)₂-SiH(SiH₃)-(SiH₂)₂-SiH₃, 2,2-disilylhexasilane SiH₃-Si(SiH₃)₂-(SiH₂)₃-SiH₃, 2,3-disilylhexasilane SiH₃-SiH(SiH₃) -SiH(SiH₃)-(SiH₂)₂-SiH₃, 2,4-disilylhexasilane SiH₃-SiH(SiH₃)-SiH₂-SiH(SiH₃)-SiH₂-SiH₃, 2,5-disilylhexasilane SiH₃-SiH(SiH₃)-(SiH₂)₂-SiH(SiH₃)- SiH₃, 3,3-disilylhexasilane SiH₃-SiH₂-Si(SiH₃)₂-(SiH₂)₂-SiH₃, 3,4-disilylhexasilane SiH₃-SiH₂-SiH(SiH₃)- SiH(SiH₃)-SiH₂-SiH₃, 2,2,3-trisilylpentasilane SiH₃-Si(SiH₃)₂-SiH(SiH₃)-SiH₂-SiH₃, 2,2,4-trisilylpentasilane SiH₃-Si(SiH₃)₂-SiH₂-SiH(SiH₃)-SiH₃, 2,3,3-trisilylpentasilane SiH₃-SiH(SiH₃)-Si(SiH₃)₂-SiH₂-SiH₃, 2,3,4-trisilylpentasilane SiH₃-SiH(SiH₃)-SiH(SiH₃)-SiH(SiH₃)-SiH₃, 2,2,3,3-tetrasilyltetrasilane SiH₃-Si(SiH₃)₂-Si(SiH₃)₂-SiH₃ and mixtures thereof;
   (c) cyclic silanes, selected from the group consisting of; cyclotrisilane Si₃H₆, cyclotetrasilane Si₄H₈, cyclopentasilane Si₅H₁₀, cyclohexasilane Si₆H₁₂, and mixtures thereof;
   (d) silyl substituted cyclic silanes, selected from the group consisting of; silyl cyclotetrasilane SiH3-Si₄H₇, 1,2-disilyl cyclopentasilane (SiH₃)₂-Si₅H₈, silyl cyclohexasilane SiH₃-Si₆H₁₁, 1,3-disilyl cyclohexasilane (SiH₃)₂-Si₆H₁₀, and mixtures thereof; and
   (e) silyl substituted silenes, selected from the group consisting of; 2-tetrasilene SiH₃-SiH=SiH-SiH₃, 2,3-disilyltetrasil-2-ene SiH₃-Si(SiH₃)=Si(SiH₃)-SiH₃, 2,3-disilylpentasil-2-ene SiH₃-Si(SiH₃)=Si(SiH₃)-SiH₂-SiH₃, 2,5-disilylhexasil-2-ene SiH₃-Si(SiH₃)=SiH-SiH2-SiH(SiH₃)-SiH₃, 2,3,4-trisilylhexasil-2-ene SiH₃-Si(SiH₃)=Si(SiH₃)-SiH(SiH₃)-SiH₂-SiH₃, and mixtures thereof; and
wherein the silane used is at 5 to 10 %, and the at least one additive used is at 0.01 to 5 %, and the rest is hydrogen.
#2. A method of deposition for a solar grade amorphous silicon film (αSi:H) according to #1, wherein the deposition is performed at a substrate temperature of 25° -500° C, and pressure of 0.01 torr to 15 torr (1.33 to 2000 Pa).
#3. A method of deposition for a solar grade amorphous silicon film (αSi:H) according to #3, wherein the substrate temperature is at 150°- 250° C.
#4. A method of deposition for a solar grade amorphous silicon film (αSi:H) according to #1, wherein the deposition is a process selected from the group consisting of Chemical Vapor Deposition (CVD), Plasma Enhanced Chemical Vapor Deposition (PECVD), Low Pressure Chemical Vapor Deposition (LPCVD), Hot Wire Chemical Vapor Deposition (HWCVD), Initiated Chemical Vapor Deposition (ICVD) and Sub Atmospheric Chemical Vapor Deposition (SA-CVD).
#5. A method of deposition for a solar grade amorphous silicon film (αSi:H) according to #1, wherein the deposition is a plasma enhanced chemical vapor deposition at a plasma power density ranging from 0.19-1.6 W/cm² and a plasma frequency ranging from 13.56 to 40.68 MHz.
#6. A method of deposition for a solar grade amorphous silicon film (αSi:H) according to #6, the method having a deposition rate ranging from 10 - 200 Å/sec.
#7. A method of deposition for a solar grade amorphous silicon film (αSi:H) according to #5, wherein the deposited film provides a single junction solar cell having efficiencies of 5 -15%; or a tandem junction solar cell having efficiencies of 7 - 20 %.
#8. A method of deposition for amorphous silicon film (αSi:H) or microcrystalline silicon film (µCSi:H) as a photoconductive film on a substrate, using
   Silane;
   hydrogen;
   at least one additive selected from the group consisting of:
   (a) higher order straight chain silanes, comprising; disilane Si₂H₆, trisilane Si₃H₈, tetrasilane Si₄H₁₀, pentasilane Si₅H₁₂, hexasilane Si₆H₁₄, heptasilane Si₇H₁₆, octasilane Si₈H₁₈, nonasilane Si₉H₂₀, decasilane Si₁₀H₂₂ and mixtures thereof;
   (b) higher order branched silanes, comprising; 2-silyl-trisilane SiH₃-Si(H)(SiH₃)-SiH₃, 2,2-disilyl-trisilane SiH₃-Si(SiH₃)₂-SiH₃, 2-silyl-tetrasilane SiH₃-Si(H)(SiH₃)-SiH₂-SiH₃, 2,3-disilyltetrasilane SiH₃-SiH(SiH₃)-SiH(SiH₃)-SiH₃, 2,2-disilyltetrasilane SiH₃-Si(SiH₃)₂-SiH₂-SiH₃, 3-silylpentasilane SiH₃-SiH₂-SiH(SiH₃)-SiH₂-SiH₃, 2-silylpentasilane SiH₃-SiH(SiH₃)-SiH₂-SiH₂-SiH₃, 2,3-disilylpentasilane SiH₃-SiH(SiH₃)-SiH(SiH₃)-SiH₂-SiH₃, 2,4-disilylpentasilane SiH₃-SiH(SiH₃)-SiH₂-SiH(SiH₃)-SiH₃, 2-silylhexasilane SiH₃-SiH(SiH₃)-(SiH₂)₃SiH₃, 3-silylhexasilane SiH₃-SiH₂-SiH(SiH₃)-(SiH₂)₂SiH₃, 2,2-disilylpentasilane SiH₃-Si(SiH₃)₂-(SiH₂)₂-SiH₃, 3,3-disilylpentasilane SiH₃-SiH₂-Si (SiH₃)₂-SiH₂ -SiH₃, 2,2,3-trisilyltetrasilane SiH₃-Si(SiH₃)₂-SiH(SiH₃)-SiH₃, 2-silylheptasilane SiH₃-SiH(SiH₃)-(SiH₂)₄-SiH₃, 3-silylheptasilane SiH₃-SiH₂-SiH(SiH₃)-(SiH₂)₃-SiH₃, 4-silylheptasilane SiH₃-(SiH₂)₂-SiH(SiH₃)-(SiH₂)₂-SiH₃, 2,2-disilylhexasilane SiH₃-Si(SiH₃)₂-(SiH₂)₃-SiH₃, 2,3-disilylhexasilane SiH₃-SiH(SiH₃) -SiH(SiH₃)-(SiH₂)₂-SiH₃, 2,4-disilylhexasilane SiH₃-SiH(SiH₃)-SiH₂-SiH(SiH₃)-SiH₂-SiH₃, 2,5-disilylhexasilane SiH₃-SiH(SiH₃)-(SiH₂)₂-SiH(SiH₃)- SiH₃, 3,3-disilylhexasilane SiH₃-SiH₂-Si(SiH₃)₂-(SiH₂)₂-SiH₃, 3,4-disilylhexasilane SiH₃-SiH₂-SiH(SiH₃)- SiH(SiH₃)-SiH₂-SiH₃, 2,2,3-trisilylpentasilane SiH₃-Si(SiH₃)₂-SiH(SiH₃)-SiH₂-SiH₃, 2,2,4-trisilylpentasilane SiH₃-Si(SiH₃)₂-SiH₂-SiH(SiH₃)-SiH₃, 2,3,3-trisilylpentasilane SiH₃-SiH(SiH₃)-Si(SiH₃)₂-SiH₂-SiH₃, 2,3,4-trisilylpentasilane SiH₃-SiH(SiH₃)-SiH(SiH₃)-SiH(SiH₃)-SiH₃, 2,2,3,3-tetrasilyltetrasilane SiH₃-Si(SiH₃)₂-Si(SiH₃)₂-SiH₃ and mixtures thereof;
   (c) cyclic silanes, selected from the group consisting of; cyclotrisilane Si₃H₆, cyclotetrasilane Si₄H₈, cyclopentasilane Si₅H₁₀, cyclohexasilane Si₆H₁₂, and mixtures thereof;
   (d) silyl substituted cyclic silanes, selected from the group consisting of; silyl cyclotetrasilane SiH3-Si₄H₇, 1,2-disilyl cyclopentasilane (SiH₃)₂-Si₅H₈, silyl cyclohexasilane SiH₃-Si₆H₁₁, 1,3-disilyl cyclohexasilane (SiH₃)₂-Si₆H₁₀, and mixtures thereof;
   (e) silyl substituted silenes, selected from the group consisting of; 2-tetrasilene SiH₃-SiH=SiH-SiH₃, 2,3-disilyltetrasil-2-ene SiH₃-Si(SiH₃)=Si(SiH₃)-SiH₃, 2,3-disilylpentasil-2-ene SiH₃-Si(SiH₃)=Si(SiH₃)-SiH₂-SiH₃, 2,5-disilylhexasil-2-ene SiH₃-Si(SiH₃)=SiH-SiH2-SiH(SiH₃)-SiH₃, 2,3,4-trisilylhexasil-2-ene SiH₃-Si(SiH₃)=Si(SiH₃)-SiH(SiH₃)-SiH₂-SiH₃, and mixtures thereof;
      and
      at least one another additive selected from the group consisting of:
   (f) halogen substituted silenes, selected from the group consisting of; monochlorosilane SiH₃Cl, dichlorosilane SiH₂Cl₂, trichlorosilane SiHCl₃, tetrachlorosilane (SiCl₄), chlorodisilane SiH₃-SiH₂Cl, and mixtures thereof; and
   (g) halogen containing gases, selected from the group consisting of; chlorine Cl₂, hydrogen chloride HCl, chlorine trifluoride ClF₃, nitrogen trifluoride NF₃, fluorine F₂, hydrogen fluoride HF, bromine Br₂, hydrogen bromide HBr, hydrogen iodide Hl and mixtures thereof; and
wherein the silane used is at 5 to 10 %, the at least one additive used is at 0.01 to 5 %, and at least one another additive is used at 0.01 to 5 %, and the rest is hydrogen.
#9. A method of deposition for an amorphous silicon film (αSi:H) or a microcrystalline silicon film (µCSi:H) according to #8, wherein the deposition is performed at a substrate temperature of 25° -500° C, and pressure of 0.01 torr to15 torr (1.33 to 2000 Pa).
#10. A method of deposition for an amorphous silicon film (αSi:H) or a microcrystalline silicon film (µCSi:H) according to #8, wherein the deposition is a process selected from the group consisting of Chemical Vapor Deposition (CVD), Plasma Enhanced Chemical Vapor Deposition (PECVD), Low Pressure Chemical Vapor Deposition (LPCVD), Hot Wire Chemical Vapor Deposition (HWCVD), Initiated Chemical Vapor Deposition (ICVD) and Sub Atmospheric Chemical Vapor Deposition (SA-CVD).
#11. A method of deposition for an amorphous silicon film (αSi:H) or a microcrystalline silicon film (µCSi:H) according to #8, wherein the deposition is a plasma enhanced chemical vapor deposition at a plasma power density ranging from 0.19-1.6 W/cm² and a plasma frequency ranging from 13.56 to 40.68 MHz.
#12. A method of deposition for an amorphous silicon film (αSi:H) or a microcrystalline silicon film (µCSi:H) according to #8, the method having a deposition rate of 10 - 200 Å/sec for amorphous silicon film (αSi:H) and 10-100 Å/sec for microcrystalline silicon film (µCSi:H).
#13. A method of deposition for an amorphous silicon film (αSi:H) or a microcrystalline silicon film (µCSi:H) according to #8, wherein the deposited amorphous silicon film (αSi:H) provides a single junction solar cell having efficiencies of 5 -15%; or the deposited amorphous silicon film (αSi:H) or microcrystalline silicon film (µCSi:H) provides a tandem junction solar cell having efficiencies of 7 - 20 %.

### Working Examples

### Deposition of Amorphous Silicon Film (αSi:H)

Hydrogen plays a critical role in the properties and formation of hydrogenated silicon (Si:H) networks. Examples of this would be in the metastability of the optoelectronic properties in amorphous hydrogenated silicon which is also known as the Staebler-Wronski Effect (SWE). Another example would be in the crystallization of Si-Si bonds during microcrystalline Si:H growth.

Infrared (IR) spectroscopy is a commonly applied analytical technique used to detect the different bending, wagging, and stretching modes (SM) of hydrides in amorphous hydrogenated and microcrystalline silicon. In the bulk layer of amorphous hydrogenated silicon there are three characteristic absorptions modes; wagging modes at 640 cm⁻¹, a scissors doublet or bending mode at 840-890 cm⁻¹ which is assigned to the di-hyrides, and the stretching modes in the range of 1895-2130 cm⁻¹. The stretching modes are of great interest due to the fact that they reflect detailed information related to the bonding environment of hydrogen in the film.

It is well understood that by using IR to analyze amorphous hydrogenated silicon for the Si-Hₓ stretching modes between 1895-2130 cm⁻¹ one can back out ratios of Si-H₂ which is also called the High Stretching Mode (HSM) at 2070-2100 cm⁻¹ and Si-H which is also call the Low Stretching Mode (LSM) at 1980-2010 cm⁻¹. Amorphous hydrogenated silicon intrinsic layers with inferior opto-electronic properties typically are dominated by Si-H₂ stretching modes.

The Empirical Microstructure Factor (R*) is a calculation where one can back out ratios of HSM and LSM. The Empirical Microstructure Factor is defined as R* = *I_{HSM}* / *(I_{LSM}* +*I_{HSM})* where *I_{HSM}* and *I_{LSM}* correspond to the integrated absorption strength of the LSM .and HSM. By definition, the R* value is the fraction or percent Si-H₂ in the film. The smaller the R* value is, the less percent of Si-H₂ is in the film. In general for amorphous hydrogenated silicon to be classified as solar grade material you need R* < 0.2, or less than 20%.

Plasma Enhanced Chemical Vapor Deposition (PECVD) was used in the present invention to deposit thin films of αSi:H for single junction solar cells and αSi:H and µCSi.:H for tandem solar cells , using silane with hydrogen and additives.

### Deposition of Amorphous Silicon Film (αSi:H)

The Empirical Microstructure Factor (R*) in amorphous hydrogenated silicon intrinsic layers produced by using Silane (SiH₄) and hydrogen can be manipulated by changing the total flow of chemical by volume and power density in a Plasma Enhanced Chemical Vapor Deposition chamber (PECVD).

Materials used to produce αSi:H and µCSi:H based solar cells include from 5 to 10% silane; from 0.9 to 1.8% of an additive or additives. Process conditions include a substrate temperature of 25° -500° C with preferred temperatures of 150° - 250° C. Process conditions include plasma powers from 10 - 10,000 watts, power densities from 019 W/cm² to 1.6W/cm² and chamber pressures from 0.01 torr to15 torr (1.33 to 2000 Pa).

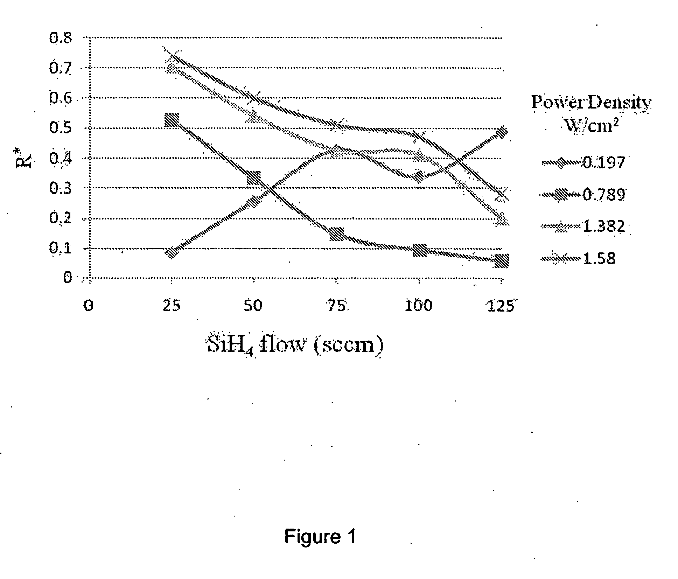

Figure 1 is a graph showing the Empirical Microstructure Factor R* of hydrogenated silicon αSi:H deposited versus SiH₄ flow rate under different power densities. The percentage of SiH₄ used was 9.0% and H₂ was 91%.

The flow rate of the SiH₄ ranged from 0 to 125 sccm; and the power densities were at 0.197, 0.789, 1.382 and 1.58 W/cm².

As the power density increased at lower flow rate range (see the flow rates < 50 sccm), the Empirical Microstructure Factors R* tended to be above 20% for all power densities. As the flow rate increased > 50 sccm, as power density increased, the Empirical Microstructure Factors R* started to decrease for all power densities, except for 0.197 W/ cm². However, it's interesting to point out that the Empirical Microstructure Factors R* did not get below 20% at higher flow rates (100 and 125 sccm) for all power densities, except at 0.789 W / cm², which led to the conclusion that these films would not produce a suitable solar grade material.

The added value of producing the Empirical Microstructure Factors R' below 20% at high power densities and high flow rates was the benefit of increased growth rates of the intrinsic films.

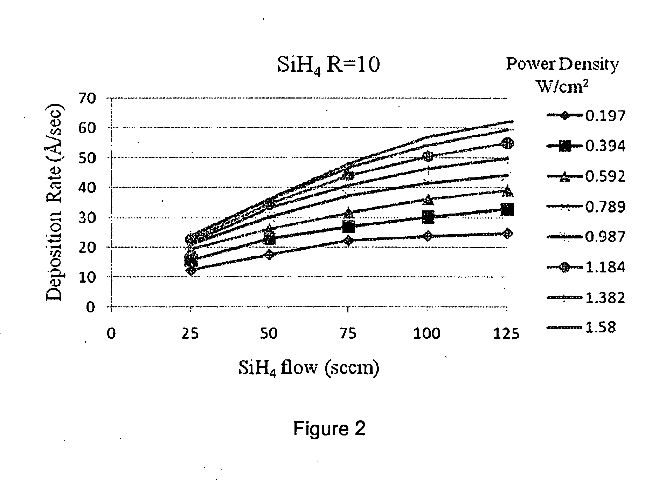

Figure 2 is a graph showing the deposition (growth) rate versus SiH₄ flow rate under different power densities. The Empirical Microstructure Factor R* for the data was at 10%. The percentage of SiH₄ used was 9.0% and H₂ was 91%. The flow rate of the SiH₄ ranged from 0 to 125 sccm; and the power densities were at 0.197, 0.394, 0.592, 0.789, 0.987, 1.184, 1.382 and 1.58 W/cm².

Figure 2 shows that as flow rates and power densities were increased, the deposition rates also increased.

Disilane was used as the at least one of additives for higher order silanes shown above in group (a). The disilane used ranged from 0.9% to 1.8%.

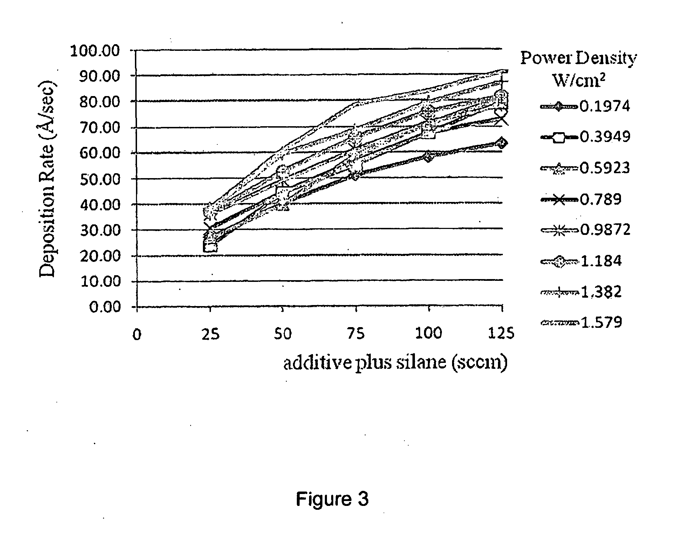

The deposition rate versus the flow rate of the mixture of silane with disilane under different power densities had been shown in figure 3. The percentage of disilane was 0.9%, silane was 8.1%, and hydrogen was 91 %.

The flow rate of the mixture of SiH₄ and disilane ranged from 0 to 125 sccm; and the power densities were at 0.197, 0.394, 0.592, 0.789, 0.987, 1.184, 1.382 and 1.58 W/cm².

By using at least one of these higher order silanes as an additive to silane in the deposition process, the amorphous phase deposition(growth) rate significantly increased as the flow rate increased at all power densities compared to the neat silane films shown in Figure 2.

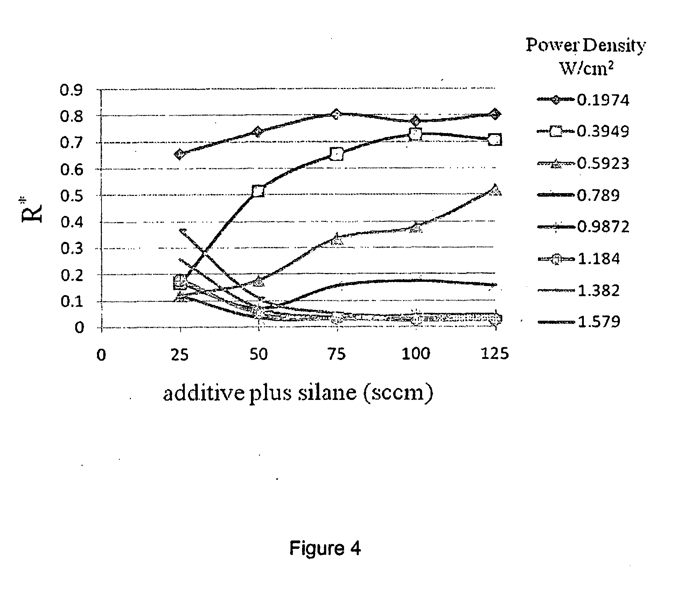

Figure 4 illustrates Empirical Microstructure Factor R* as a function of the flow rate of a mixture of silane with trisilane at different power densities (the trisilane being used as the at least one additive). The percentage of Trisilane was 0.9%, Silane was at 8.1%, and Hydrogen was at 91%.The flow rate of the mixture of SiH₄ and trisilane ranged from 0 to 125 sccm; and the power densities were at 0.197, 0.394, 0.592, 0.789, 0.987, 1.184, 1.382 and 1.58 W/cm².

Figure 4 shows that as the flow rates of the mixture of silane and trisilane increased, R* value, that is, the % of Si-H₂ in the film decreased to less than 20% for all power densities greater than and equal to 0.789 W/cm². This gave the added benefit of increased growth rate with an Empirical Microstructure Factor R* below 20% to produce a suitable solar grade material.

However, the R* values did not reach <20% for the power densities less than and equal to 0.5923 W/cm². This indicated that these films would not be a suitable solar grade material.

Thus, to deposit a suitable solar grade silicon film, both the Empirical Microstructure Factor R* value and the deposition rate are important factors.

As shown above in Figure 4, although the deposition rates were higher at power densities less than and equal to 0.5923 W/cm² (comparing with the data shown in Figure 2—no disilane used), however, due to the higher R* values (>20%), no suitable solar grade films can be deposited with trisilane as an additive at those power densities.

### Deposition of Microcrystalline Silicon Film (µCSi:H)

The dual benefit of faster deposition and higher photoconductance can be achieved through the use of dual functional additives designed to incorporate the chemical features required to achieve both types of process enhancement.

The enhancement of growth rate and maintenance of photoconductivity can be achieved through addition of at least one higher order silane from groups (a) to (e), while by incorporating at least one additional moiety from groups (h) and (i), such as a halogen, on the silane or higher order silane, microcrystaline fraction is increased and the impact of film defects and impurities is reduced.

For example, molecules such as monchlorosilane (SiH₃Cl or MCS), dichlorosilane (SiH₂Cl₂), chlorodisilane (Si₂H₅Cl₂) can be used as the at least one additional additives, in addition to growth rate enhancing higher order silane, such as disilane and trisilane to the process yielding higher fractions of microcrystalinity in the deposited film.

PECVD process is used in depositing the microcrystalline silicon film (µCSi:H).

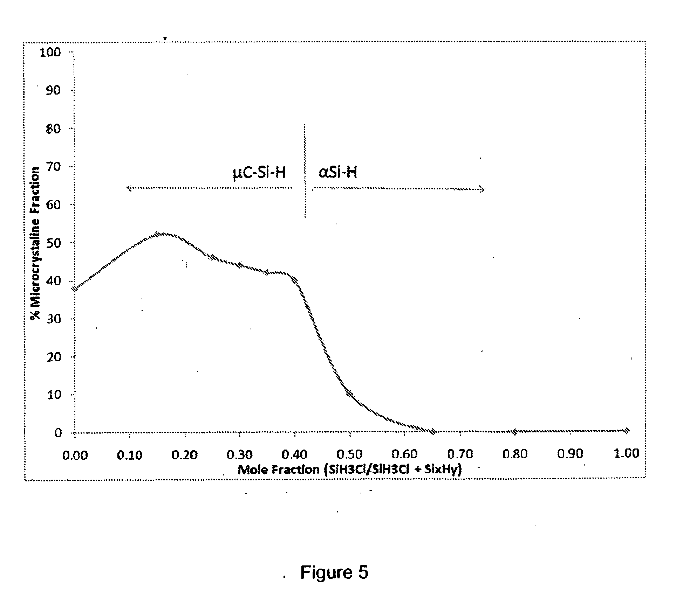

For the data obtained in Figure 5, monchlorosilane (SiH₃Cl) was used as the at least one additional additive, the higher order silanes being represented in the Figure by SiₓH_{y}, wherein x = 2 to 20 and y= 6 to 42.

The mixture of the halogenated silane SiH₃Cl with silane (SiH₄) and higher order silanes (SiₓH_{y}) is represented by (SiH₃Cl + Si_{X}H_{Y}), wherein x = 2 to 20 and y= 6 to 42. The mole fraction SiH₃Cl / (SiH₃Cl + Si_{X}H_{Y}) is the ratio of the halogenated silane SiH₃Cl (MCS) to the mixture of the halogenated silane SiH₃Cl with silane (SiH₄) and higher order silanes (SiₓH_{y}),

The flow rate of H₂ ranges from 91 to 99 %, the flow rate of the mixture ranges from 1% to 9%. The preferred embodiment of the example is (SiH₃Cl + SiₓH_{Y}) flows of 1 - 2 % and H₂ flows of 98 - 99% based on the reactor plasma frequency of 13.56 MHz.

Those skilled in the art will realize that higher plasma frequencies, such as 40.68 MHz, will permit higher, relative (SiH₃Cl + SiₓH_{Y}) flows.

The film deposition in Figure 5 is performed at 13.56 MHz using 1-9% silane, 1-9% higher order silane, and 1-9% SiH₃Cl, with total Si containing moieties not exceeding 9 % ((SiH₄ + SiH₃Cl + SiₓH_{y}) < or equal 9 %). The preferred embodiment of the present example is to use 1-2% silane, 0.1 - 0.2 % higher order silane (SiₓH_{y}), 0.1 - 0.2 % MCS, and with balance being hydrogen.

Figure 5 shows the results of the change of the microcrystalline fraction as the function of the mole fraction of SiH₃Cl / (SiH₃Cl + SiₓH_{y}). Applicants have found that all the higher order silanes functioned the same.

When no SiH₃Cl is added, the Microcrystalline fraction is around 38%. The microcrystalline fraction reaches an optimum value about 51% at approximately 0.18 mole fraction of SiH₃Cl / (SiH₃Cl + SiₓH_{y}) %, and trends down until the film becomes amorphous at > 0.5 mole fraction. An optimal amount of Cl added to the deposition aids in the nucleation process for microcrystalline formation. As more Cl is added the film trends towards the amorphous phase. The specific mechanisms yielding optimized microcrystaline fractions at a given Cl partial pressure in the plasma are not fully understood but are suspected of being related to Cl aiding in the microcrystalline seeding process. Excess Cl disrupts the structured deposition of microcrystalline yielding higher degrees of amorphous silicon fractions within the deposited film.

Figure 5 clearly indicates that the use of halogen substituted silanes in addition of higher order silanes will increase the microcrystalline fraction, providing an optimal band gap for the microcrystalline layer of 1.2 eV as part of the tandem solar cell.

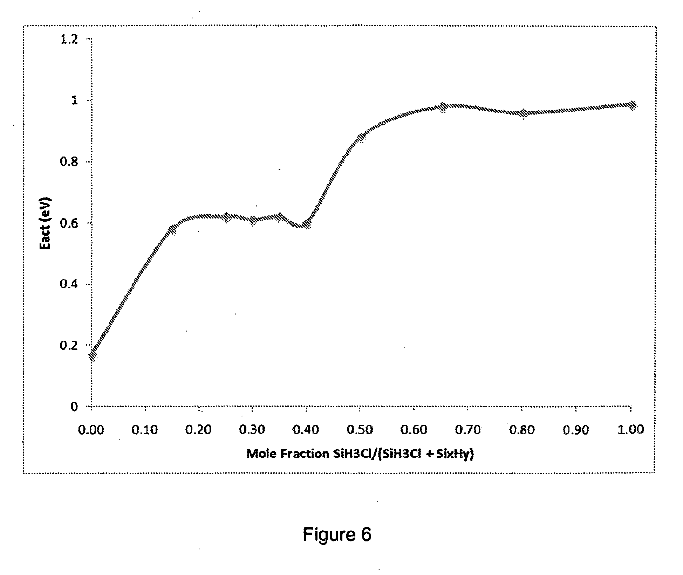

The film deposition conditions used in Figure 6 were the same as in Figure 5.

Figure 6 shows the dark current activation energy versus the mole fractions of halogenated silanes SiH₃Cl / (SiH₃Cl + Si_{X}H_{Y}) %, wherein Si_{X}H_{Y} = SiH₄ + SiₓH_{y} wherein x = 2 - 20 and y = 6 - 42. The dark current activation energy is the energy required to generate charge carriers in the absence of light for deposited microcrystalline

As demonstrated in Figure 6, the dark current activation energy (E_{ACT}) is impacted by the addition of chlorine to the process. The effect of chlorine addition increases dark current E_{ACT} from 0.2 eV to approximately 0.6 eV indicating that the effects of chlorine addition are reduction of the effects of donor impurities such as oxygen on the deposited microcrystalline film at low mole fractions from 0.10 to 0.40 of halogenated silanes SiH₃Cl / (SiH₃Cl + SiₓH_{y}), compared to the absence of added chlorine.

As shown in Figure 6, at high chlorine mole fractions > 0.5 , E_{ACT} increases as the film transitions from microcrystalline to amorphous phase.

Those results are believed to be attributed to Cl acting as an impurity scavenger reducing the doping capacity of impurities. The enhancement in photoconductivity is realized by shifting the Fermi level to mid band gap for the enhanced growth rate intrinsic microcrystalline film.

The shift in Fermi level to the middle of the band gap at ca. 0.6 eV provides the optimal electrical bias for a p-i-n type photovoltaic device that is the subject of this invention. The electrical bias inherent to the p-i-n structure aids in separation of charge carriers created in the intrinsic Si layer thus leading to higher degree of current extraction and higher degree of solar cell efficiency. The use of the appropriate quantity of halogen during deposition, from 0.1 to 0.4 mole fraction of the silane containing moieties, yields a film that is less impacted from the defects, such as impurity incorporation, that can occur during higher deposition rates.

Figures 5 and 6 demonstrate that the use of higher order silanes and Halogen substituted silanes will increase the deposition rate, the microcrystalline fraction, and enhance the photoconductivity of the film. The present invention has demonstrated that the deposition of αSi:H and µCSi:H at deposition rates 2- 20 times higher than industry averages reported above. These include deposition rates for αSi:H of 10 - 200 Å/sec and for µCSi:H of 2 - 100 Å/sec.

The deposited αSi:H films for formation of single junction solar cells had efficiencies of 5 -15 %. The deposited αSi:H and µCSi:H films for forming tandem junction solar cells had efficiencies of 7 - 20 %. Solar cell efficiency is defined as: Solar cell efficiency (%) =(Power out (W) x 100%) / (Area (m²) x 1000 W/m²). These efficiency improvements were the result of the addition of additives to the deposited films yielding enhanced photoconductivity.

The foregoing examples and description of the embodiments should be taken as illustrating, rather than as limiting the present invention as defined by the claims. As will be readily appreciated, numerous variations and combinations of the features set forth above can be utilized without departing from the present invention as set forth in the claims. Such variations are intended to be included within the scope of the following claims.

## Claims

1. A method of deposition for an amorphous silicon film (αSi:H) or microcrystalline silicon film (µCSi:H) as a photoconductive film on a substrate, using
Silane;
hydrogen;
at least one additive selected from:
(a) higher order straight chain silanes, selected from; disilane Si₂H₆, trisilane Si₃H₈, tetrasilane Si₄H₁₀, pentasilane Si₅H₁₂, hexasilane Si₆H₁₄, heptasilane Si₇H₁₆, octasilane Si₈H₁₈, nonasilane Si₉H₂₀, decasilane Si₁₀H₂₂, other straight chain silanes of the general formula SiₓH₂ₓ₊₂ where x is 2 to 20, and mixtures thereof;
(b) higher order branched silanes, selected from; 2-silyl-trisilane SiH₃-Si(H)(SiH₃)-SiH₃, 2,2-disilyl-trisilane SiH₃-Si(SiH₃)₂-SiH₃, 2-silyl-tetrasilane SiH₃-Si(H)(SiH₃)-SiH₂-SiH₃, 2,3-disilyltetrasilane SiH₃-SiH(SiH₃)-SiH(SiH₃)-SiH₃, 2,2-disilyltetrasilane SiH₃-Si(SiH₃)₂-SiH₂-SiH₃, 3-silylpentasilane SiH₃-SiH₂-SiH(SiH₃)-SiH₂-SiH₃, 2-silylpentasilane SiH₃-SiH(SiH₃)-SiH₂-SiH₂-SiH₃, 2,3-disilylpentasilane SiH₃-SiH(SiH₃)-SiH(SiH₃)-SiH₂-SiH₃, 2,4-disilylpentasilane SiH₃-SiH(SiH₃)-SiH₂-SiH(SiH₃)-SiH₃, 2-silylhexasilane SiH₃-SiH(SiH₃)-(SiH₂)₃SiH₃, 3-silylhexasilane SiH₃-SiH₂-SiH(SiH₃)-(SiH₂)₂SiH₃, 2,2-disilylpentasilane SiH₃-Si(SiH₃)₂-(SiH₂)₂-SiH₃, 3,3-disilylpentasilane SiH₃-SiH₂-Si (SiH₃)₂-SiH₂ -SiH₃, 2,2,3-trisilyltetrasilane SiH₃-Si(SiH₃)₂-SiH(SiH₃)-SiH₃, 2-silylheptasilane SiH₃-SiH(SiH₃)-(SiH₂)₄-SiH₃, 3-silylheptasilane SiH₃-SiH₂-SiH(SiH₃)-(SiH₂)₃-SiH₃, 4-silylheptasilane SiH₃-(SiH₂)₂-SiH(SiH₃)-(SiH₂)₂-SiH₃, 2,2-disilylhexasilane SiH₃-Si(SiH₃)₂-(SiH₂)₃-SiH₃, 2,3-disilylhexasilane SiH₃-SiH(SiH₃) -SiH(SiH₃)-(SiH₂)₂-SiH₃, 2,4-disilylhexasilane SiH₃-SiH(SiH₃)-SiH₂-SiH(SiH₃)-SiH₂-SiH₃, 2,5-disilylhexasilane SiH₃-SiH(SiH₃)-(SiH₂)₂-SiH(SiH₃)- SiH₃, 3,3-disilylhexasilane SiH₃-SiH₂-Si(SiH₃)₂-(SiH₂)₂-SiH₃, 3,4-disilylhexasilane SiH₃-SiH₂-SiH(SiH₃)- SiH(SiH₃)-SiH₂-SiH₃. 2,2,3-trisilylpentasilane SiH₃-Si(SiH₃)₂-SiH(SiH₃)-SiH₂-SiH₃, 2,2,4-trisilylpentasilane SiH₃-Si(SiH₃)₂-SiH₂-SiH(SiH₃)-SiH₃, 2,3,3-trisilylpentasilane SiH₃-SiH(SiH₃)-Si(SiH₃)₂-SiH₂-SiH₃, 2,3,4-trisilylpentasilane SiH₃-SiH(SiH₃)-SiH(SiH₃)-SiH(SiH₃)-SiH₃, 2,2,3,3-tetrasilyltetrasilane SiH₃-Si(SiH₃)₂-Si(SiH₃)₂-SiH₃, other branched silanes of the general formula SiₓH₂ₓ₊₂ where x is 4 to 20, and mixtures thereof;
(c) cyclic silanes, selected from; cyclotrisilane Si₃H₆, cyclotetrasilane Si₄H₈, cyclopentasilane Si₅H₁₀, cyclohexasilane Si₆H₁₂, other cyclic silanes of the general formula SiₓH₂ₓ where x is 3 to 20, and mixtures thereof;
(d) silyl substituted cyclic silanes, selected from; silyl cyclotetrasilane SiH₃-Si₄H₇, 1,2-disilyl cyclopentasilane (SiH₃)₂-Si₅H₈, silyl cyclohexasilane SiH₃-Si₆H₁₁, 1,3-disilyl cyclohexasilane (SiH₃)₂-Si₆H₁₀, other silyl substituted cyclosilanes of the general formula Si_{y}H_{3y}-SiₓH_{2x-y} where x is 3 to 20 and y is 1 to 2x, and mixtures thereof; and
(e) silyl substituted silenes, selected from; 2-tetrasilene SiH₃-SiH=SiH-SiH₃, 2,3-disilyltetrasil-2-ene SiH₃-Si(SiH₃)=Si(SiH₃)-SiH₃, 2,3-disilylpentasil-2-ene SiH₃-Si(SiH₃)=Si(SiH₃)-SiH₂-SiH₃, 2,5-disilylhexasil-2-ene SiH₃-Si(SiH₃)=SiH-SiH₂-SiH(SiH₃)-SiH₃, 2,3,4-trisilylhexasil-2-ene SiH₃-Si(SiH₃)=Si(SiH₃)-SiH(SiH₃)-SiH₂-SiH₃, other silyl substituted silenes of the general formula Si_{y}H_{3y}-SiₓH_{2x-y} where x is 2 to 20 and y is 1 to 2x, and mixtures thereof; and
optionally at least one additional additive selected from:
(h) halogen substituted silanes, selected from; monochlorosilane SiH₃Cl, dichlorosilane SiH₂Cl₂, trichlorosilane SiHCl₃, tetrachlorosilane (SiCl₄), chlorodisilane SiH₃-SiH₂Cl, and mixtures thereof; and
(i) halogen containing gases, selected from; chlorine Cl₂, hydrogen chloride HCl, chlorine trifluoride ClF₃, nitrogen trifluoride NF₃, fluorine F₂, hydrogen fluoride HF, bromine Br₂, hydrogen bromide HBr, hydrogen iodide HI and mixtures thereof;
wherein the silane used is at 5 to 10 % (v/v), the at least one additive used is at 0.01 to 5 % (v/v), the at least one additional additive when used is at 0.01 to 5 % (v/v), and the rest is hydrogen.

2. The method of Claim 1, the method using
Silane;
hydrogen;
at least one additive selected from (a) to (e); and
at least one additional additive selected from (h) and (i).

3. The method of any one of the preceding claims, wherein the deposition is performed at a substrate temperature of 25° -500° C, and pressure of 1.33 to 2000 Pa (0.01 torr to15 torr).

4. The method of Claim 3, wherein the substrate temperature is at 150°-250° C.

5. The method of any one of the preceding claims, wherein the deposition is a process selected from the group consisting of Chemical Vapor Deposition (CVD), Plasma Enhanced Chemical Vapor Deposition (PECVD), Low Pressure Chemical Vapor Deposition (LPCVD), Hot Wire Chemical Vapor Deposition (HWCVD), Initiated Chemical Vapor Deposition (ICVD) and Sub Atmospheric Chemical Vapor Deposition (SA-CVD).

6. The method of any one of the preceding claims, wherein the deposition is a plasma enhanced chemical vapor deposition at a plasma power density ranging from 0.19-1.6 W/cm² and a plasma frequency ranging from 13.56 to 40.68 MHz.

7. The method of claim 6, wherein the method is a method for deposition of an amorphous silicon film (αSi:H) at a deposition rate of 10 - 200 Å/sec, or is a method for deposition of a microcrystalline silicon film (µCSi:H) at a deposition rate of 10 -100 Å/sec.

8. The method of claim 6 or 7, wherein the method is a method for deposition of an amorphous silicon film (αSi:H) to provide a single junction solar cell having efficiencies of 5 -15%; or is a method for deposition of an amorphous silicon film (αSi:H) or microcrystalline silicon film (µCSi:H) to provide a tandem junction solar cell having efficiencies of 7 - 20 %.

## Patentansprüche

1. Verfahren zur Abscheidung einer amorphen Siliziumschicht (αSi:H) oder einer microkristallinen Siliziumschicht (µCSi:H) als eine fotoleitende Schicht auf einem Substrat, wobei
Silan;
Wasserstoff;
mindestens ein Additiv, ausgewählt aus:
(a) gradkettigen Silanen höherer Ordnung, ausgewählt aus;
Disilan Si₂H₆, Trisilan Si₃H₈, Tetrasilan Si₄H₁₀, Pentasilan Si₅H₁₂, Hexasilan Si₆H₁₄, Heptasilan Si₇H₁₆, Octasilan Si₈H₁₈, Nonasilan Si₉H₂₀, Decasilan Si₁₀H₂₂, anderen gradkettigen Silanen mit der allgemeinen Formel SiₓH₂ₓ₊₂, worin x 2 bis 20 ist, und Mischungen davon;
(b) verzweigten Silanen höherer Ordnung, ausgewählt aus;
2-Silyl-trisilan SiH₃-Si(H)(SiH₃)-SiH₃, 2,2-Disilyl-trisilan SiH₃-Si(SiH₃)₂-SiH₃, 2-Silyl-tetrasilan SiH₃-Si(H)(SiH₃)-SiH₂-SiH₃, 2,3-Disilyltetrasilan SiH₃-SiH(SiH₃)-SiH(SiH₃)-SiH₃, 2,2-Disilyltetrasilan SiH₃-Si(SiH₃)₂-SiH₂-SiH₃, 3-Silylpentasilan SiH₃-SiH₂-SiH(SiH₃)-SiH₂-SiH₃, 2-Silylpentasilan SiH₃-SiH(SiH₃)-SiH₂-SiH₂-SiH₃, 2,3-Disilylpentasilan SiH₃-SiH(SiH₃)-SiH(SiH₃)-SiH₂-SiH₃, 2,4-Disilylpentasilan SiH₃-SiH(SiH₃)-SiH₂-SiH(SiH₃)-SiH₃, 2-Silylhexasilan SiH₃-SiH(SiH₃)-(SiH₂)₃SiH₃, 3-Silylhexasilan SiH₃-SiH₂-SiH(SiH₃)-(SiH₂)₂SiH₃, 2,2-Disilylpentasilan SiH₃-Si(SiH₃)₂-(SiH₂)₂-SiH₃, 3,3-Disilylpentasilan SiH₃-SiH₂-Si(SiH₃)₂-SiH₂-SiH₃, 2,2,3-Trisilyltetrasilan SiH₃-Si(SiH₃)₂-SiH(SiH₃)-SiH₃, 2-Silylheptasilan SiH₃-SiH(SiH₃)-(SiH₂)₄-SiH₃, 3-Silylheptasilan SiH₃-SiH₂-SiH(SiH₃)-(SiH₂)₃-SiH₃, 4-Silylheptasilan SiH₃-(SiH₂)₂-SiH(SiH₃)-(SiH₂)₂-SiH₃, 2,2-Disilylhexasilan SiH₃-Si(SiH₃)₂-(SiH₂)₃-SiH₃, 2,3-Disilylhexasilan SiH₃-SiH(SiH₃)-SiH(SiH₃)-(SiH₂)₂-SiH₃, 2,4-Disilylhexasilan SiH₃-SiH(SiH₃)-SiH₂-SiH(SiH₃)-SiH₂-SiH₃, 2,5-Disilylhexasilan SiH₃-SiH(SiH₃)-(SiH₂)₂-SiH(SiH₃)-SiH₃, 3,3-Disilylhexasilan SiH₃-SiH₂-Si(SiH₃)₂-(SiH₂)₂-SiH₃, 3,4-Disilylhexasilan SiH₃-SiH₂-SiH(SiH₃)-SiH(SiH₃)-SiH₂-SiH₃, 2,2,3-Trisilylpentasilan SiH₃-Si(SiH₃)₂-SiH(SiH₃)-SiH₂-SiH₃, 2,2,4-Trisilylpentasilan SiH₃-Si(SiH₃)₂-SiH₂-SiH(SiH₃)-SiH₃, 2,3,3-Trisilylpentasilan SiH₃-SiH(SiH₃)-Si(SiH₃)₂-SiH₂-SiH₃, 2,3,4-Trisilylpentasilan SiH₃-SiH(SiH₃)-SiH(SiH₃)-SiH(SiH₃)-SiH₃, 2,2,3,3-Tetrasilyltetrasilan SiH₃-Si(SiH₃)₂-Si(SiH₃)₂-SiH₃, anderen verzweigten Silanen mit der allgemeinen Formel SiₓH₂ₓ₊₂, worin x 4 bis 20 ist, und Mischungen davon;
(c) cyclischen Silanen, ausgewählt aus;
Cyclotrisilan Si₃H₆, Cyclotetrasilan Si₄H₈, Cyclopentasilan Si₅H₁₀, Cyclohexasilan Si₆H₁₀, anderen cyclischen Silanen mit der allgemeinen Formel SiₓH₂ₓ, worin x 3 bis 20 ist, und Mischungen davon;
(d) Silyl-substituierten cyclischen Silanen, ausgewählt aus;
Silyl-cyclotetrasilan SiH₃-Si₄H₇, 1,2-Disilyl-cyclopentasilan (SiH₃)₂-Si₅H₈, Silyl-cyclohexasilan SiH₃-Si₆H₁₁, 1,3-Disilyl-cyclohexasilan (SiH₃)₂-Si₆H₁₀, anderen Silyl-substuierten Cyclosilanen mit der allgemeinen Formel Si_{y}H_{3y}-SiₓH_{2x-y}, worin x 3 bis 20 und y 1 bis 2x ist, und Mischungen davon; und
(e) Silyl-substituierten Silenen, ausgewählt aus;
2-Tetrasilen SiH₃-SiH=SiH-SiH₃, 2,3-Disilyltetrasil-2-en SiH₃-Si(SiH₃)=Si(SiH₃)-SiH₃, 2,3-Disilylpentasil-2-en SiH₃-Si(SiH₃)=Si(SiH₃)-SiH₂-SiH₃, 2,5-Disilylhexasil-2-en SiH₃-Si(SiH₃)=SiH-SiH₂-SiH(SiH₃)-SiH₃, 2,3,4-Trisilylhexasil-2-en SiH₃-Si(SiH₃)=Si(SiH₃)-SiH(SiH₃)-SiH₂-SiH₃, anderen Silyl-substituierten Silenen mit der allgemeinen Formel Si_{y}H_{3y}-SiₓH_{2x-y}, worin x 2 bis 20 und y 1 bis 2x ist, und Mischungen davon; und
optional mindestens ein zusätzliches Additiv, ausgewählt aus:
(h) Halogen-substituierten Silanen, ausgewählt aus;
Monochlorsilan SiH₃Cl, Dichlorsilan SiH₂Cl₂, Trichlorsilan SiHCl₃, Tetrachlorsilan (SiCl₄), Chlordisilan SiH₃-SiH₂Cl und Mischungen davon; und
(i) Halogen-haltigen Gasen, ausgewählt aus;
Chlor Cl₂, Chlorwasserstoff HCl, Chlortrifluorid ClF₃, Stickstofftrifluorid NF₃, Fluor F₂, Fluorwasserstoff HF, Brom Br₂, Bromwasserstoff HBr, Iodwasserstoff HI und Mischungen davon,
verwendet werden,
wobei das verwendete Silan 5 bis 10 % (v/v) beträgt, das verwendete mindestens eine Additiv 0,01 bis 5 % (v/v) beträgt, das mindestens eine zusätzliche Additiv, wenn es verwendet wird, 0,01 bis 5 % (v/v) beträgt und der Rest Wasserstoff ist.

2. Verfahren nach Anspruch 1, wobei das Verfahren
Silan;
Wasserstoff;
mindestens ein Additiv, ausgewählt aus (a) bis (e); und
mindestens ein weiteres Additiv, ausgewählt aus (h) und (i),
verwendet.

3. Verfahren nach einem der vorhergehenden Ansprüche, wobei die Abscheidung bei einer Substrattemperatur von 25 - 500 °C und einem Druck von 1,33 bis 2000 Pa (0,01 Torr bis 15 Torr) durchgeführt wird.

4. Verfahren nach Anspruch 3, wobei die Substrattemperatur bei 150 - 250 °C ist.

5. Verfahren nach einem der vorhergehenden Ansprüche, wobei die Abscheidung ein Verfahren ausgewählt aus der Gruppe, bestehend aus chemischer Gasphasenabscheidung (CVD), plasmaunterstützter chemischer Gasphasenabscheidung (PECVD), Niederdruck-chemischer Gasphasenabscheidung (LPCVD), Heißdraht-chemischer Gasphasenabscheidung (HWCVD), initiierter chemischer Gasphasenabscheidung (ICVD) und Unterdruck-chemischer Gasphasenabscheidung (SA-CVD), ist.

6. Verfahren nach einem der vorhergehenden Ansprüche, wobei die Abscheidung eine plasmaunterstützte chemische Gasphasenabscheidung mit einer Plasmaleistungsdichte, die von 0,19 - 1,6 W/cm² reicht, und einer Plasmafrequenz, die von 13,56 bis 40,68 MHz reicht, ist.

7. Verfahren nach Anspruch 6, wobei das Verfahren ein Verfahren zur Abscheidung einer amorphen Siliziumschicht (αSi:H) bei einer Abscheidungsgeschwindigkeit von 10 - 200 Å/s oder ein Verfahren zur Abscheidung einer microkristallinen Siliziumschicht (µCSi:H) bei einer Abscheidungsgeschwindigkeit von 10 - 100 Å/s ist.

8. Verfahren nach Anspruch 6 oder 7, wobei das Verfahren ein Verfahren zur Abscheidung einer amorphen Siliziumschicht (αSi:H), um eine Einfachsolarzelle bereitzustellen, die Wirkungsgrade von 5 - 15 % hat; oder ein Verfahren zur Abscheidung einer amorphen Siliziumschicht (αSi:H) oder microkristallinen Siliziumschicht (µCSi:H), um eine Tandemsolarzelle bereitzustellen, die Wirkungsgrade von 7 - 20 % hat, ist.

## Revendications

1. Procédé de dépôt d'un film de silicium amorphe (αSi:H) ou d'un film de silicium microcristallin (µCSi:H) en tant que film photoconducteur sur un substrat, en utilisant
un silane ;
de l'hydrogène ;
au moins un additive choisi parmi :
(a) les silanes à chaîne linéaire d'ordre supérieur choisis parmi ; le disilane Si₂H₆, le trisilane Si₃H₈, le tétrasilane Si₄H₁₀, le pentasilane Si₅H₁₂, l'hexasilane Si₆H₁₄, l'heptasilane Si₇H₁₆, l'octasilane Si₈H₁₈, le nonasilane Si₉H₂₀, le décasilane Si₁₀H₂₂, d'autres silanes à chaîne linéaire de formule générale SiₓH₂ₓ₊₂ où x est 2 à 20, et leurs mélanges ;
(b) les silanes ramifiés d'ordre supérieur choisis parmi ; le 2-silyl-trisilane SiH₃-Si(H)(SiH₃)-SiH₃, le 2,2-disilyl-trisilane SiH₃-Si(SiH₃)₂-SiH₃, le 2-silyl-tétrasilane SiH₃-Si(H)(SiH₃)-SiH₂-SiH₃, le 2,3-disilyltétrasilane SiH₃-SiH(SiH₃)-SiH(SiH₃)-SiH₃, le 2,2-disilyltétrasilane SiH₃-Si(SiH₃)₂-SiH₂-SiH₃, le 3-silylpentasilane SiH₃-SiH₂-SiH(SiH₃)-SiH₂-SiH₃, le 2-silylpentasilane SiH₃-SiH(SiH₃)-SiH₂-SiH₂-SiH₃, le 2,3-disilylpentasilane SiH₃-SiH(SiH₃)-SiH(SiH₃)-SiH₂-SiH₃, le 2,4-disilylpentasilane SiH₃-SiH(SiH₃)-SiH₂-SiH(SiH₃)-SiH₃, le 2-silylhexasilane SiH₃-SiH(SiH₃)-(SiH₂)₃SiH₃, le 3-silylhexasilane SiH₃-SiH₂-SiH(SiH₃)-(SiH₂)₂SiH₃, le 2,2-disilylpentasilane SiH₃-Si(SiH₃)₂-(SiH₂)₂-SiH₃, le 3,3-disilylpentasilane SiH₃-SiH₂-Si(SiH₃)₂-SiH₂-SiH₃, le 2,2,3-trisilyltétrasilane SiH₃-Si(SiH₃)₂-SiH(SiH₃)-SiH₃, le 2-silylheptasilane SiH₃-SiH(SiH₃)-(SiH₂)₄-SiH₃, le 3-silylheptasilane SiH₃-SiH₂-SiH(SiH₃)-(SiH₂)₃-SiH₃, le 4-silylheptasilane SiH₃-(SiH₂)₂-SiH(SiH₃)-(SiH₂)₂-SiH₃, le 2,2-disilylhexasilane SiH₃-Si(SiH₃)₂-(SiH₂)₃-SiH₃, le 2,3-disilylhexasilane SiH₃-SiH(SiH₃)-SiH(SiH₃)-(SiH₂)₂-SiH₃, le 2,4-disilylhexasilane SiH₃-SiH(SiH₃)-SiH₂-SiH(SiH₃)-SiH₂-SiH₃, le 2,5-disilylhexasilane SiH₃-SiH(SiH₃)-(SiH₂)₂-SiH(SiH₃)-SiH₃, le 3,3-disilylhexasilane SiH₃-SiH₂-Si(SiH₃)₂-(SiH₂)₂-SiH₃, le 3,4-disilyl-hexasilane SiH₃-SiH₂-SiH(SiH₃)-SiH(SiH₃)-SiH₂-SiH₃, le 2,2,3-trisilylpentasilane SiH₃-Si(SiH₃)₂-SiH(SiH₃)-SiH₂-SiH₃, le 2,2,4-trisilylpentasilane SiH₃-Si(SiH₃)₂-SiH₂-SiH(SiH₃)-SiH₃, le 2,3,3-trisilylpentasilane SiH₃-SiH(SiH₃)-Si(SiH₃)₂-SiH₂-SiH₃, le 2,3,4-trisilylpentasilane SiH₃-SiH(SiH₃)-SiH(SiH₃)-SiH(SiH₃)-SiH₃, le 2,2,3,3-tétrasilyltétrasilane SiH₃-Si(SiH₃)₂-Si(SiH₃)₂-SiH₃, d'autres silanes ramifiés de formule générale SiₓH₂ₓ₊₂ où x est 4 à 20, et leurs mélanges ;
(c) les silanes cycliques choisis parmi ; le cyclotrisilane Si₃H₆, le cyclotétrasilane Si₄H₈, le cyclopentasilane Si₅H₁₀, le cyclohexasilane Si₆H₁₂, d'autres silanes cycliques de formule générale SiₓH₂ₓ où x est 3 à 20, et leurs mélanges ;
(d) les silanes cycliques substitués par un silyle choisis parmi ; le silyl cyclotétrasilane SiH₃-Si₄H₇, le 1,2-disilyl cyclopentasilane (SiH₃)₂-Si₅H₈, le silyl cyclohexasilane SiH₃-Si₆H₁₁, le 1,3-disilyl cyclohexasilane (SiH₃)₂-Si₆H₁₀, d'autres cyclosilanes à substituant silyle de formule générale Si_{y}H_{3y}-SiₓH_{2x-y} où x est 3 à 20 et y est 1 à 2x, et leurs mélanges ;
(e) les silènes substitués par un silyle choisis parmi ; le 2-tétrasilène SiH₃-SiH=SiH-SiH₃, le 2,3-disilyltétrasil-2-ène SiH₃-Si(SiH₃)=Si(SiH₃)-SiH₃, le 2,3-disilylpentasil-2-ène SiH₃-Si(SiH₃)=Si(SiH₃)-SiH₂-SiH₃, le 2,5-disilylhexasil-2-ène SiH₃-Si(SiH₃)=SiH-SiH₂-SiH(SiH₃)-SiH₃, le 2,3,4-trisilylhexasil-2-ène SiH₃-Si(SiH₃)=Si(SiH₃)-SiH(SiH₃)-SiH₂-SiH₃, d'autres silènes à substituant silyle de formule générale Si_{y}H_{3y}-SiₓH_{2x-y} où x est 2 à 20 et y est 1 à 2x, et leurs mélanges ; et
éventuellement au moins un additif supplémentaire choisi parmi :
(h) les silanes substitués par un halogène choisis parmi : le monochlorosilane SiH₃Cl, le dichlorosilane SiH₂Cl₂, le trichlorosilane SiHCl₃, le tétrachlorosilane (SiCl₄), le chlorodisilane SiH₃-SiH₂Cl, et leurs mélanges ; et
(i) les gaz contenant un halogène choisi parmi ; le chlore Cl₂, le chlorure d'hydrogène HCl, le trifluorure de chlore ClF₃, le trifluorure d'azote NF₃, le fluor F₂, le fluorure d'hydrogène HF, le brome Br₂, le bromure d'hydrogène HBr, l'iodure d'hydrogène HI et leurs mélanges ;
dans lequel le silane est utilisé à raison de 5 % à 10 % (v/v), le au moins un additif est utilisé à raison de 0,01 % à 5 % (v/v), le au moins un additif supplémentaire, quand il est utilisé, est utilisé à raison de 0,01 % à 5 % (v/v), et le reste est de l'hydrogène.

2. Procédé selon la revendication 1, le procédé utilisant
un silane ;
de l'hydrogène
au moins un additif choisi parmi (a) à (e) ; et
au moins un additif supplémentaire choisi parmi (h) et (i).

3. Procédé selon l'une quelconque des revendications précédentes, dans lequel le dépôt est réalisé à une température du substrat de 25 °C à 500 °C et sous une pression de 1,33 Pa à 2000 Pa (0,01 torr à 15 torr).

4. Procédé selon la revendication 3, dans lequel la température du substrat est de 150 °C à 250 °C.

5. Procédé selon l'une quelconque des revendications précédentes, dans lequel le dépôt est un procédé choisi dans le groupe consistant en le dépôt chimique en phase vapeur (CVD), le dépôt chimique en phase vapeur assisté par plasma (PECVD), le dépôt chimique en phase vapeur à basse pression (LPCVD), le dépôt chimique en phase vapeur assisté par filament chaud (HWCVD), le dépôt chimique en phase vapeur initié (ICVD) et le dépôt chimique en phase vapeur sous pression sub-atmosphérique (SA-CVD).

6. Procédé selon l'une quelconque des revendications précédentes, dans lequel le dépôt est un dépôt chimique en phase vapeur assisté par plasma à une densité de puissance de plasma allant de 0,19 W/cm² à 1,6 W/cm² et à une fréquence de plasma allant de 13,56 MHz à 40,68 MHz.

7. Procédé selon la revendication 6, dans lequel le procédé est un procédé de dépôt d'un film de silicium amorphe (αSi:H) à une vitesse de dépôt de 10 Å/seconde à 200 Å/seconde, ou un procédé de dépôt d'un film de silicium microcristallin (µCSi:H) à une vitesse de dépôt de 10 Å/seconde à 100 Å/seconde.

8. Procédé selon la revendication 6 ou 7, dans lequel le procédé est un procédé de dépôt d'un film de silicium amorphe (αSi:H) permettant d'obtenir une cellule solaire à jonction unique présentant des rendements de 5 % à 15 % ; ou un procédé de dépôt d'un film de silicium amorphe (αSi:H) ou d'un film de silicium microcristallin (µCSi:H) permettant d'obtenir une cellule solaire à jonction tandem présentant des rendements de 7 % à 20 %.
